(19) Europäisches Patentamt
European Patent Office
Office européen des brevets

(11) **EP 4 270 503 A1**

(12) **EUROPEAN PATENT APPLICATION**

(43) Date of publication:
**01.11.2023 Bulletin 2023/44**

(21) Application number: **22169708.9**

(22) Date of filing: **25.04.2022**

(51) International Patent Classification (IPC):
$H01L\ 39/22^{(2006.01)}$    $H01L\ 39/24^{(2006.01)}$
$H01L\ 43/08^{(2006.01)}$    $H01L\ 43/10^{(2006.01)}$
$H01L\ 43/12^{(2006.01)}$

(52) Cooperative Patent Classification (CPC):
**H10N 60/12; H10N 50/01; H10N 50/10;
H10N 50/85; H10N 60/0912**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Max-Planck-Gesellschaft zur
Förderung der
Wissenschaften e.V.
80539 München (DE)**

(72) Inventors:
• **PARKIN, S.P., Stuart
06118 Halle (DE)**
• **SIVAKUMAR, Keerthi, Pranava
06108 Halle (DE)**
• **PAL, Banabir
06108 Halle (DE)**

(74) Representative: **Schweitzer, Klaus
Plate Schweitzer Zounek
Patentanwälte
Rheingaustrasse 196
65203 Wiesbaden (DE)**

(54) **RACETRACK MEMORY READING DEVICE BASED ON JOSEPHSON DIODE EFFECT**

(57) The present invention relates to a reading element for a racetrack memory (RTM), comprising two superconducting electrodes (S) made of a superconducting material, which electrodes are separated by a topological metal (N) with a spin-polarized surface state, which exhibits a band inversion. The invention further relates to a method of making such a reading element as well as to its use, specifically in a racetrack memory.

**Figure 2 (a)**

## Description

The present invention relates to a superconducting reading device for racetrack memories based on the Josephson diode effect.

Background

Today we live in a digital world in which ever-increasing massive quantities of data are stored in the "cloud", with concomitantly ever more energy consumption. At the same time the evolution of conventional silicon-based computing systems has reached the end of Moore's law. Novel memory and computing devices are needed that can use less energy. The leading non-volatile, high-performance memories today are, arguably the spintronic memories MRAM (Magnetoresistive Random Access Memory) and RTM (Racetrack Memory) [see e.g. US-B 6,834,005; US-A 2014/204648]. MRAM like many other conventional memories, does not function well at low temperatures: MRAM requires thermal fluctuations for its operation that are suppressed at low temperatures. On the other hand, RTM is deterministic and thus, in principle, can operate even at the lowest temperatures. RTM is unique among memories in that it is a "shift register" in which data is encoded by the presence or absence of chiral domain walls and these data bits are shifted back and forth concurrently along magnetic nano-wires or "racetracks" by current pulses.

Aside from the challenge to store an ever-increasing massive quantity of data at lowest possible energy consumption, there is great interest today to develop quantum computers to perform tasks that are not possible with classical computing. Quantum computing goes beyond the concept of encoding data in memories and logic circuits as "1"s and "0"s to rather using the phase of a wavefunction that can take any value. The most advanced of these use superconducting or spin qubits and operate at ultra-low temperatures (~10-20 mK), well below room temperature. Most research efforts are focused on the analog quantum memory and logic gates and extending their coherence times, as well as developing circuits that incorporate them. High-frequency signals (GHz) are needed to set up and read out these qubits and the number of the needed signal lines goes in tandem with the number of qubits. For practical applications vast increases in the number of qubits are needed beyond what is possible today (~50). The heat load of this wiring and the large complexity of the needed electronics means that scaling up to large number of qubits within a dilution refrigerator is very difficult. To overcome this issue, classical control circuits are typically operated at room temperature, although significant efforts to develop cryo-CMOS that could operate at lower temperatures but above that of the quantum qubits are being spent. The significant physical separation of the digital control circuits from the analogue quantum cores results in significant latency and performance issues.

A critical bottleneck device in all of these high-performance memory devices is the reading device, which determines how and at what speed the data are read out from the memory. Specifically, in order to increase read-out speed it would be desirable to work with superconducting materials which would operate at the lowest possible resistance and, therefore, highest speed, and, at the same time consume less energy. One of the most interesting phenomena in superconductivity is the Josephson effect, a remarkable physical phenomenon wherein a junction formed from two superconducting electrodes separated by a non-superconducting barrier becomes superconducting, and the critical current of this junction can be modulated by altering the phase difference between the respective wave functions across the junction. Ever since the discovery of the Josephson effect there have been many studies to develop memory devices and logic circuits utilizing the non-linear response of a Josephson junction (JJ) as a computing and (volatile) memory element with the potential of energy-efficient, ultrafast computing. Switches based on JJs can in principle, operate at speeds in the sub-THz (picosecond) regime with very low heat dissipation. Even though current supercomputing technology requires energy for cryogenic cooling, it nevertheless offers a significant competitive advantage over CMOS technology when scaled to the exascale (i.e. about $1 \times 10^{18}$ FLOPS (floating point operations per sec) or more).

A problem with memory devices and logic circuits utilizing the non-linear response of a Josephson junction (JJ) is that JJs are not sensitive to the direction of any applied magnetic field and, therefore, a single JJ cannot serve as a reading element in a racetrack device.

Object of the Invention

It was, therefore, an object of the present invention to provide a reading element for RTMs based on a Josephson junction (JJ) which is sensitive to the direction of the electrical current and which can operate at very high speeds in the sub-THz (picosecond) regime with very low heat dissipation.

Brief description of the invention

It was found that the critical current of a Josephson junction (JJ) strongly depends on the direction of an applied magnetic field which means that a device can be tuned systematically with an external magnetic field, which in turn means that the device can be used to detect magnetic fields.

Accordingly, the present invention concerns a reading element for RTMs, which comprises two superconducting electrodes (S) made of a superconducting material, which electrodes are separated by a topological metal (N) with a spin-polarized surface state, which exhibits a band inversion, preferably a two-dimensional, centrosymmetric, type-II, Dirac semi-metal, more preferred a member of the family of column-10 transition metal ditellurides, most preferred by $NiTe_2$.

Brief description of the Drawings

Figure 1 is an Illustration of a complete racetrack memory device including a racetrack layer (1), a write element (2), a read head (3) and a shift element (4) to move magnetic bits along the racetrack.

Figure 2a is a Schematic of an S-N-S device. (N: Normal. S: Superconductor) formed from Nb-$NiTe_2$-Nb.

Figure 2b is the Crystal structure of $NiTe_2$ shown along two different crystal directions.

Figure 2c is an image of a JJ device

Figure 2d shows Voltage vs current (V-I) characteristics showing a dramatic difference in the critical Josephson current $I_c$ for positive and negative current directions.

Figure 2e shows the rectification effect showing a JDE.

Figure 2f shows the Magnetic field dependent evolution of the non-reciprocal current $\Delta I_c$, showing a sign reversal.

Figure 3: Electrical characterization of the Josephson junction devices.

Figure 3a: Current (I)-voltage (V) curves for three Josephson junctions with superconducting electrode separations, d = 120, 350 and 580 nm.

Figure 3b: Dependence of the normal state resistance ($R_n$) on d for three devices.

Figure 3c: Dependence of the critical voltage on d.

Figure 4: $NiTe_2$ JJ device and the observation of a Josephson Diode effect.

Figure 4b-c: Schematic illustrations of the Josephson device and the corresponding fermi surface. In the absence of both in-plane magnetic field and the Josephson current, the weak link contains spin-orbit coupled helical surface states, as schematically shown in the bottom panel of Fig. 4b. As discussed in the text, in the presence of an in-plane magnetic field, the helical surface state acquires a momentum shift $q_x = q_x(B_y)$, as shown in Fig. 4c. When the Josephson current flows through the junction (I/+ cor-

responds to the Josephson current flowing in the +x direction), the critical current is different depending on its direction.

Figure 4d: Voltage as a function of temperature at zero field for a JJ device with d = 350 nm that shows two transitions at $T_{SC}$ and $T_J$. Inset of Fig. 4d shows the variation of $T_{SC}$ and $T_J$ with d.

Figure 4e: *I-V* curve of a JJ device with d = 350 nm at 20 mK and an in-plane magnetic field $B_y$ = 20 mT showing a large non-reciprocal critical current, $I_{c-}$ and $I_{c+}$.

Figure 4f: Rectification effect observed using currents between $|I_{c-}|$ and $I_{c+}$ for the same JJ device at 20 mK and $B_y$ = 20 mT.

Figure 5 relates to the dependence of $\Delta I_c$ on in-plane magnetic field, angle and temperature.

Figure 5a: Variation of $\Delta I_c$ as a function of By at selected temperatures in a JJ device with d = 350 nm.

Figures 5b-c: Dependence of $\Delta I_c$ as a function of in-plane magnetic field applied at different angles with respect to the current direction and the corresponding color contour map for the same device. $\theta = 0°$ / $\pm 180°$ (and $\pm 90°$) correspond to the in-plane magnetic field being perpendicular (and parallel) to the current direction.

Figure 5d: Dependence of $\Delta I_c$ on temperature for $B_y$ = 12 mT for the same device. Inset shows a quadratic dependence $(T - T_J)^2$ of the $\Delta I_c$ on temperature close to $T_J$.

Figures 5e-f: Calculation of the dependence of $\Delta I_c$ on the angle of the in-plane magnetic field and the corresponding color map, performed from eq. (7) at $B_d$ = 22 mT and $B_c$ = 45 mT.

Detailed description of the invention

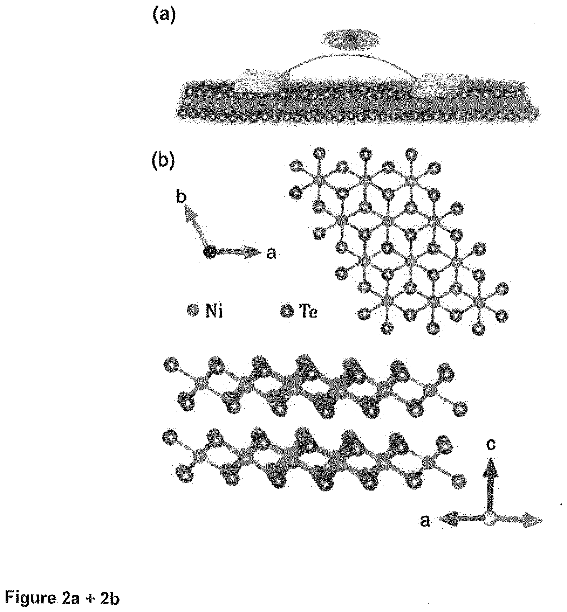

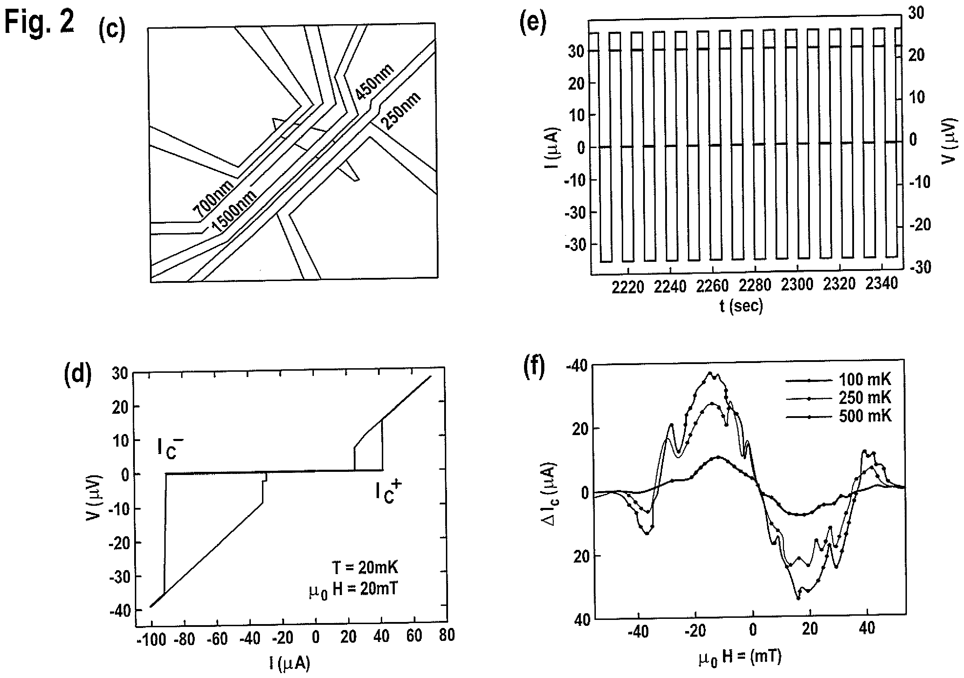

The present invention builds upon a non-reciprocal superconducting phenomenon, the so-called Josephson Diode Effect (JDE). The inventors have found that the critical current for proximity induced superconductivity in layers of a type-II Dirac semi-metal, $NiTe_2$ (see Fig. 2a, b), is distinct for current flowing in opposite directions (see Fig. 2d). The critical current depends upon the direction in which the current flows in the presence of small magnetic fields. The JDE can be tuned systematically with an external magnetic field, so that the device can be used to detect magnetic fields (see Fig. 2f). Accordingly, a JD in proximity to a perpendicularly magnetized magnetic bit on a racetrack can serve as the reading element of the memory, since the critical current strongly depends on the direction of the magnetic field. Thus, since the Josephson Diode Effect is asymmetric with respect to the direction of the stray magnetic field, when a suitable current is pulsed, one magnetic domain would produce a zero-voltage superconducting state across the JD while the other domain would produce a finite non-zero voltage across the JD.

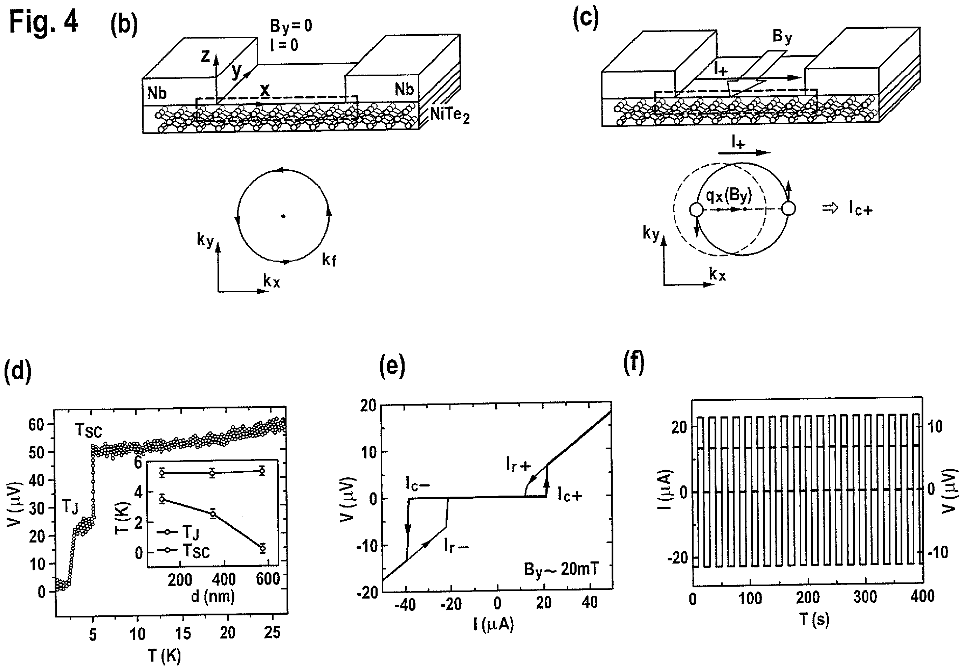

The reading element for RTMs according to the present invention comprises two superconducting electrodes (S) made of a superconducting material, which electrodes are separated by a topological metal (N) with a spin-polarized surface state which exhibits a band inversion as shown in Fig. 2(c). The lateral spacing between the superconducting electrodes can be varied from about 10 nm to about 1 micron. It is to be understood, that the "separation" of the two electrodes means the spatial distance between the two electrodes, wherein the space between the two electrodes may or may not be filled with the topological metal (N); i.e. it includes the design, where the two electrodes are deposited onto the surface of the topological metal (N) spaced apart by the lateral spacing of about 10 nm to about 1 micron (see Figure 4b-c).

Preferably the topological metal is a two-dimensional, centrosymmetric, type-II Dirac semi-metal which exhibits a band inversion. The metal is preferably selected from members of the family of column-10 transition metal ditellurides (Ni, Pd, Pt). All members in this family ($NiTe_2$, $PdTe_2$, $PtTe_2$) are type-II Dirac semimetals and host spin-polarized surface states. A centrosymmetric type-II Dirac semimetal preserves inversion symmetry, and should, therefore, not exhibit a JDE. It is, thus, believed that topological surface or interface states are responsible for the observed properties. Indeed, $NiTe_2$ exhibits unique spin-polarized surface states.

The superconducting material of the superconducting electrodes (S) preferably is a known bulk topological superconductor. Typical superconducting materials which can be used for this purpose are known and e.g. described in https://en.wikipedia.org/wiki/List_of_superconductors, examples of which are: Al, Be, Bi, Ga, Hf, $\alpha$-La, $\beta$-La, Mo, Nb, Os, Pb, Re, Rh, Ru, Sn, Ta, $\alpha$-Th, Ti, V, $\alpha$-W, $\beta$-W, Zn, Zr, $FeB_4$, InN, $In_2O_3$, $LaB_6$, $MgB_2$, $Nb_3Al$, $NbC_{1-x}N_x$, $Nb_3Ge$, NbO, NbN, $Nb_3Sn$, NbTi, TiN, $V_3Si$, $YB_6$, ZrN, $ZrB_{12}$, YBCO (Yttrium barium copper oxide), BSCCO (Bismuth strontium calcium copper oxide), HBCCO (Mercury bismuth calcium copper oxide), preferably Nb or NbN.

The lateral spacing between the superconducting electrodes can be varied from about 10 nm to about 1 micron.

In the racetrack memory device the reading element of the present invention is arranged proximal to the racetrack magnetic layers, preferably 0.5 nm to 100 nm from the racetrack magnetic layers, preferably 0.5 nm to 10 nm, or more preferably 0.5 to 5 nm from the these layers. This proximal distance is preferably accomplished with a separating layer. The separating layer can be selected from a metal with low spin-orbit coupling, e.g. Al, Cu or Be.

## Manufacture of the JJ device

First a thin layer of the Dirac semi-metal e.g. $NiTe_2$ is exfoliated from a bulk crystal of the Dirac semi-metal and placed on a substrate e.g. $SiO_2$. Then the superconducting contacts are fabricated e.g. using an electron beam lithography based method. Before exposure, each substrate is spin coated e.g. with an AR-P 679.03 resist followed by annealing at elevated temperatures, e.g. 150 °C. After electron beam exposure and subsequent development, contact electrodes are formed from sputter-deposited superconductor, e.g. tri-layers of 2 nm Ti / 30 nm Nb /20 nm Au to thereby create the Josephson junction (JJ) devices.

The present invention is illustrated by the following examples.

## Examples

Thin $NiTe_2$ flakes were exfoliated from a high quality $NiTe_2$ single crystal (from HQ Graphene company) using a standard scotch tape exfoliation technique and placed on a Si (100) substrate with a 280 nm thick $SiO_2$ on top. The exfoliation was carried out in a glove box under a nitrogen atmosphere, with water and oxygen levels each below 1 ppm. The thinnest flakes were identified from their optical contrast in an optical microscope and used subsequently to prepare devices. X-ray photoelectron spectroscopy (XPS) was performed on the exfoliated flakes to verify the composition. Angle resolved photoelectron spectroscopy (ARPES) measurements were carried out on the single crystal after in-situ cleaving.

All the devices used were fabricated using an electron beam lithography based method. Before exposure, each substrate was spin coated with an AR-P 679.03 resist at 4000 rpm for 60 sec followed by annealing at 150 °C for 60 sec. After electron beam exposure and subsequent development, contact electrodes were formed from sputter-deposited tri-layers of 2 nm Ti / 30 nm Nb /20 nm Au for the Josephson junction (JJ) devices.

Electrical transport measurements were performed in a Bluefors LD-400 dilution refrigerator with a base temperature of 20 mK and equipped with high frequency electronic filters (from QDevil Aps). Angle-dependent magnetic field measurements were carried out using a 2D superconducting vector magnet integrated within the Bluefors system. A small consistent offset in the magnetic field, of the order of ~1.5 mT, was observed while sweeping the magnetic field due to likely flux trapping within the superconducting magnet coils. Direct current-voltage characteristics of the JJ devices were measured using a Keithley 6221 current source and a Keithley 2182A nanovoltmeter. Differential resistance measurements were performed using a Zurich Instruments MFLI lock-in amplifier with a multi-demodulator option using a standard low-frequency (3-28 Hz) lock-in technique. The critical currents for the Fraunhofer pattern were measured in combination with a Keithley 2636B voltage source to sweep the DC bias.

$NiTe_2$ is a layered van der Waals materials which can be easily exfoliated. It crystallizes in a trigonal crystal structure with the space group $P_{\overline{3}m1}$. The crystal structure is comprised of $NiTe_2$ tri-layers stacked along the c axis, each tri-layer composed of a Ni sheet sandwiched between two Te sheets. The crystal structure of $NiTe_2$ along two crystallographic directions is shown in Fig. 2b.

Atomic force microscopy (AFM) measurements were performed on the devices to measure both the thicknesses of the $NiTe_2$ flakes as well as to estimate the distance between the superconducting electrodes in the Josephson junction devices. A typical AFM image of a device is shown in the inset of Fig. 2c

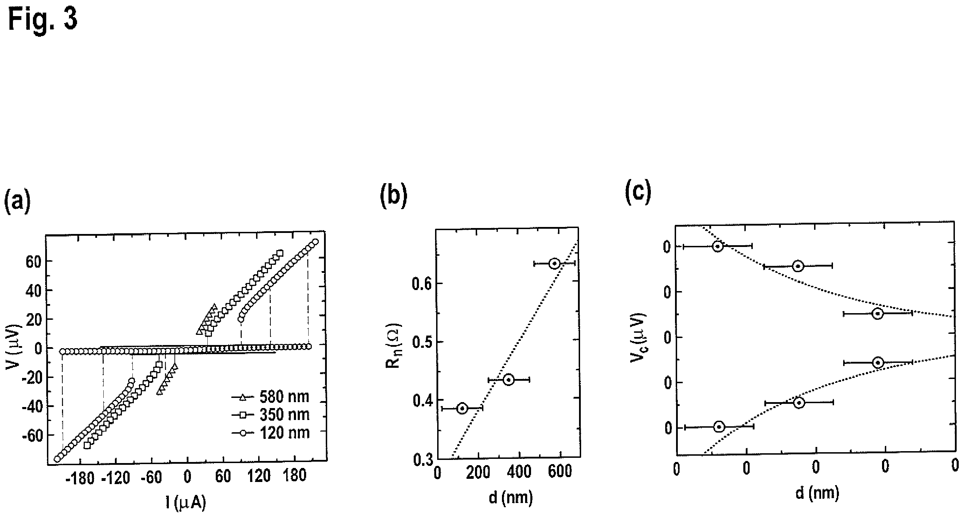

Fig. 3a shows current ($I$) - voltage ($V$) curves for three Josephson junctions with superconducting electrode separations, d = 120, 350 and 580 nm at T = 20 mK in the absence of any magnetic field. It can be seen clearly that there is no diode effect in the absence of a magnetic field. Large hysteresis in the $I$-$V$ curves suggest that the devices are in the underdamped regime. With increasing $d$, the normal state resistance ($R_n$) determined from the slope of the $I$-$V$ curve increases (Fig. 3b) and the corresponding critical current ($I_c$) decreases (Fig. 3a), as expected for a proximity-induced Josephson junction. The fitting of the d dependence of the characteristic voltage ($V_c = I_c R_n$) using an exponential dependence

$$\sim e^{\left(-\frac{d}{\xi}\right)}$$ shows that the characteristic decay length ($\xi$) in this device is ~ 414 nm (Fig. 3c).

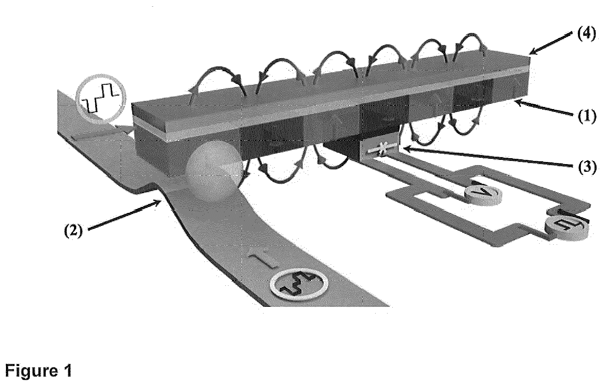

A schematic of the JJ device is shown in Fig. 4b-c, in the absence and presence of Josephson current, respectively, where x is parallel to the current direction and z is the out-of-plane direction. The temperature dependence of the resistance of the device with d = 350 nm (Fig. 1d) shows two transitions: the first transition ($T_{SC}$) at ~ 5.3 K is related to the superconducting electrodes. A second transition ($T_J$) takes place at a lower temperature when the device enters the Josephson transport regime such that a supercurrent flows through the $NiTe_2$ layer. The dependence of both $T_{SC}$ and $T_J$ as a function of the edge-to-edge separation, d, between the electrodes is shown in the inset of Fig. 4d. While $T_{SC}$ is independent of $d$, $T_J$ decreases with increasing $d$, which corroborates that $T_J$ corresponds to the superconducting proximity transition of the JJ device.

To observe the JDE (see illustration in Fig. 4b-c), current versus voltage ($I$-$V$) measurements were carried out as a function of temperature and magnetic field. Fig. 4e shows $I$-$V$ curves in the presence of an in-plane magnetic field $B_y$ ~ 20 mT perpendicular to the direction of the current for the device with d = 350 nm. The device exhibits four different values of the critical current with a large hysteresis indicating that the JJs are in the underdamped regime. During the negative to positive current sweep (from -50 μA to +50 μA) the device shows two critical currents $I_{r-}$ and $I_{c+}$ whereas during a positive to negative current sweep (from +50 μA to -50 μA) the device exhibits two other critical currents $I_{r+}$ and $I_{c-}$. The critical currents $I_{c-}$ and $I_{c+}$, correspond to the critical values of the supercurrent when the system is still superconducting. For small magnetic fields, the absolute magnitude of $I_{c-}$ is clearly much larger than that of $I_{c+}$ (Fig. 4e). For zero field data $I_{c+} = |I_{c-}|$. These different values of $I_{c+}$ and $|I_{c-}|$ mean that when the absolute value of the applied current lies between $I_{c+}$ and $|I_{c-}|$, the system will behave as a superconductor for the current along one direction while a normal dissipative metal for the current along the opposite direction. This difference demonstrates a clear rectification effect, as shown in Fig. 4f, that occurs for currents which are larger than $I_{c+}$ but smaller than $|I_{c-}|$.

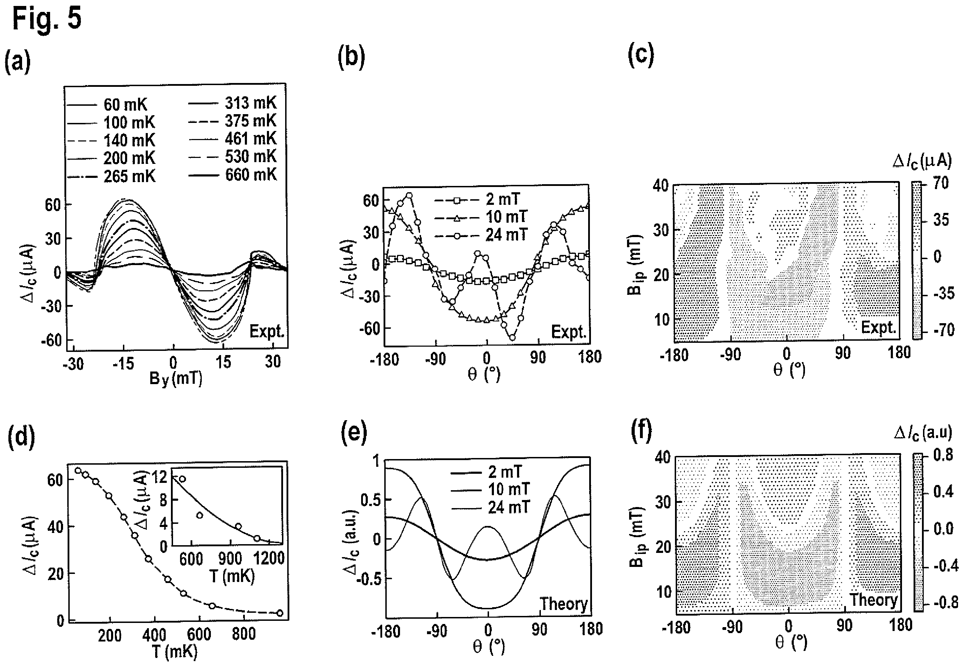

To probe the origin of the JDE, the evolution of $\Delta I_c$ ($\Delta I_c \equiv I_{c+} - |I_{c-}|$) was examined as a function of applied in-plane magnetic field at various temperatures and angles with respect to the current direction. The dependence of $\Delta I_c$ on $B_y$ (field parallel to the y axis and perpendicular to the current) at different temperatures demonstrates that $\Delta I_c$ is antisymmetric with respect to $B_y$ (Fig. 5a). At 60 mK, $\Delta I_c$ exhibits a maximum and a minimum value at $B_y = \mp 12$ mT, respectively (Fig. 5a) and the ratio

$\dfrac{\Delta I_c}{\langle I_c \rangle}$ is as large as 60%, where $\langle I_c \rangle = \dfrac{(I_{c+} + |I_{c-}|)}{2}$ .

Such a large magnitude of $\dfrac{\Delta I_c}{\langle I_c \rangle}$ at a low magnetic field (~ 12 mT) makes this system unique, as compared to previous reports where either the magnitude of $\dfrac{\Delta I_c}{\langle I_c \rangle}$ was found to be small, or a large magnetic field was required to observe a significant effect. Also, multiple sign reversals were observed in $\Delta I_c$ when $B_{ip}$ is increased, a previously unobserved and interesting dependence.

The dependence of $\Delta I_c$ on the direction of the in-plane magnetic field with respect to the current is shown in Fig. 5b-c, for several field strengths. At small fields, $|\Delta I_c|$ is largest when the field is perpendicular to the current ($\theta = 0°/\pm180°$, where $\theta$ is the in-plane angle measured with respect to the $y$-axis) and vanishes when the field and current are parallel ($\theta = \pm90°$). With regard to the temperature dependence of $\Delta I_c$, it was found that the magnitude of $\Delta I_c$ increases monotonically as the temperature is lowered (Fig. 5a). For a quantitative understanding, the temperature dependence of $\Delta I_c$ for $B_y = 12$ mT (the field at which $\Delta I_c$ takes the largest value) is shown in Fig. 5d. At temperatures near $T_J$, the variation of $\Delta I_c$

with temperature can be well fitted by the equation $\Delta I_c = \alpha(T - T_J)^2$ (inset of Fig. 5d).

Figs. 5e-f show the dependencies of $\Delta I_c$ on the magnitude of $B_y$ and the direction of the in-plane magnetic field as obtained from our phenomenological model, where $B_c$ = 45 mT and $B_d \approx 22$ mT was used. In order to explain the angular direction dependence, it was taken into account that the non-reciprocal part of the current is proportional only to the x-component of the momentum shift ($q_x$) that is proportional to the $B_y (= B_{ip} \cos \theta)$ component of the in-plane magnetic field. In Fig. 5f it is shown that in each domain

$$-\frac{\pi}{2} + \pi n < \theta < \frac{\pi}{2} + \pi n,$$

the sign reversal of $\Delta I_c$ occurs where the condition

$$\sin \left( \pi \frac{B_{ip} \cos \theta}{B_d} \right) = 0$$

is fulfilled, which one can see clearly in Fig. 5c. Thus, this model successfully captures the main features of the JDE as seen in the experimental data.

In summary, these data show that a JJ device involving a type-II Dirac semimetal NiTe$_2$ exhibits a large non-reciprocal critical current. The effect is antisymmetric with respect to the magnetic field perpendicular to the current direction and exhibits a $(T - T_J)^2$ temperature dependence.

## Claims

1. Reading element for a racetrack memory (RTM), comprising two superconducting electrodes (S) made of a superconducting material, which electrodes are separated by a topological metal (N) with a spin-polarized surface state, which exhibits a band inversion.

2. Reading element according to claim 1, wherein the topological metal is a two-dimensional, centrosymmetric, type-II, Dirac semi-metal.

3. Reading element according to claim 1 or 2, wherein the topological metal is NiTe$_2$, PdTe$_2$ or PtTe$_2$.

4. Reading element according to claim 3, wherein the topological metal is NiTe$_2$.

5. Reading element according to one of claims 1-4, wherein the superconducting material of the superconducting electrodes (S) are selected from: Al, Be, Bi, Ga, Hf, $\alpha$-La, $\beta$-La, Mo, Nb, Os, Pb, Re, Rh, Ru, Sn, Ta, $\alpha$-Th, Ti, V, $\alpha$-W, $\beta$-W, Zn, Zr, FeB4, InN, In$_2$O$_3$, LaB$_6$, MgB2, Nb3Al, NbC$_{1-x}$N$_x$, Nb$_3$Ge, NbO, NbN, Nb$_3$Sn, NbTi, TiN, V$_3$Si, YB$_6$, ZrN, ZrB$_{12}$, YB-CO (Yttrium barium copper oxide), BSCCO (Bismuth strontium calcium copper oxide), HBCCO (Mercury bismuth calcium copper oxide), preferably Nb or NbN.

6. Reading element according to one of claims 1-5, wherein the lateral spacing between the superconducting electrodes is from about 10 nm to about 1 micron.

7. A racetrack memory (RTM) device comprising a reading element according to claim 1.

8. The racetrack memory (RTM) device according to claim 7, wherein the reading element is arranged at a proximal distance to the racetrack of 0.5 nm to 100 nm, preferably 0.5 to 10 nm, more preferred 0.5 to 5 nm.

9. The racetrack memory (RTM) device according to claim 8, wherein the proximal distance is accomplished with a separating layer wherein the separating layer material is selected from a metal with low spin-orbit coupling, e.g. Al, Cu or Be.

10. Method of manufacturing a reading element according to claim 1, comprising exfoliating a thin layer of a Dirac semi-metal from a bulk crystal of the Dirac semi-metal, placing the exfoliated thin layer on a substrate, then fabricating two superconducting contacts using electron beam lithography.

11. Use of a reading element according to claim 1 as electronic switch.

12. Use of a reading element according to claim 1 in a quantum computer.

Figure 1

(a)

(b)

b

a

◉ Ni    ◉ Te

c

a

Figure 2a + 2b

Fig. 2

(c)

(e)

(d)

(f)

EP 4 270 503 A1

# Fig. 3

(a)

(b)

(c)

Fig. 4

(b) $B_y = 0$  $I = 0$

(c) $B_y$

(d)

(e)

(f)

**Fig. 5**

Europäisches
Patentamt

European
Patent Office

Office européen
des brevets

# EUROPEAN SEARCH REPORT

**Application Number**

EP 22 16 9708

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Pal Banabir ET AL: "Josephson diode effect from Cooper pair momentum in a topological semimetal", arXiv, 21 December 2021 (2021-12-21), XP055972026, DOI: 10.48550/arXiv.2112.11285 Retrieved from the Internet: URL:https://arxiv.org/ftp/arxiv/papers/2112/2112.11285.pdf [retrieved on 2022-10-17] | 1-6, 10-12 | INV. H01L39/22 H01L39/24 H01L43/08 H01L43/10 H01L43/12 |
| Y | * page 2, line 14 – page 3, line 33; figure 1 * | 7-9 | |
| Y | US 2020/294565 A1 (APALKOV DMYTRO [US] ET AL) 17 September 2020 (2020-09-17) * paragraph [0040] – paragraph [0043]; figure 1 * | 7-9 | |

|  |
|---|
| **TECHNICAL FIELDS SEARCHED (IPC)** |
| H01L |

The present search report has been drawn up for all claims

| Place of search | Date of completion of the search | Examiner |
|---|---|---|
| Munich | 17 October 2022 | Gröger, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 22 16 9708**

This annex lists the patent family members relating to the patent documents cited in the above-mentioned European search report.
The members are as contained in the European Patent Office EDP file on
The European Patent Office is in no way liable for these particulars which are merely given for the purpose of information.

**17-10-2022**

| Patent document cited in search report | Publication date | Patent family member(s) | Publication date |
|---|---|---|---|
| US 2020294565 A1 | 17-09-2020 | KR 20200110145 A<br>US 2020294565 A1 | 23-09-2020<br>17-09-2020 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6834005 B

- US 2014204648 A